Europäisches Patentamt

European Patent Office

Office européen des brevets

(19)

(11) **EP 0 655 137 B1**

(12) **EUROPÄISCHE PATENTSCHRIFT**

(45) Veröffentlichungstag und Bekanntmachung des Hinweises auf die Patenterteilung:
**15.05.1996 Patentblatt 1996/20**

(21) Anmeldenummer: 93917547.7

(22) Anmeldetag: **09.08.1993**

(51) Int Cl.⁶: $G01R\ 19/00$

(86) Internationale Anmeldenummer:
**PCT/DE93/00723**

(87) Internationale Veröffentlichungsnummer:
**WO 94/04931 (03.03.1994 Gazette 1994/06)**

(54) **PEGELMESSGERÄT**

LEVEL MEASURING SET

HYPSOMETRE

(84) Benannte Vertragsstaaten:
**DE FR GB**

(30) Priorität: **17.08.1992 DE 4227166**

(43) Veröffentlichungstag der Anmeldung:
**31.05.1995 Patentblatt 1995/22**

(73) Patentinhaber: **SIEMENS AKTIENGESELLSCHAFT D-80333 München (DE)**

(72) Erfinder: **HOFFMANN, Klaus D-81735 München (DE)**

(56) Entgegenhaltungen:
**DE-A- 3 831 678       DE-B- 1 791 225**
**DE-C- 3 924 049       US-A- 4 030 016**

## Beschreibung

Gegenstand der Erfindung ist ein Pegelmeßgerät für gleichspannungsbehaftete NF-Signale.

Die Meßzeit beim automatischen Pegelmessen ist im wesentlichen durch die untere Grenzfrequenz des Meßgleichrichters bestimmt.

Zur Ankopplung des Pegelmeßgeräts an gleichspannungsbehaftete NF-Signale werden im allgemeinen Koppelkondensatoren verwendet. Diese wirken sich störend auf die Meßzeit aus, da Umladevorgänge in den Koppelkondensatoren, hervorgerufen durch Schaltspitzen, Übersteuerungen etc. stattfinden.

Aus der deutschen Patentschrift 38 31 678 ist eine Schaltungsanordnung zur Spitzenwertmessung eines einem Gleichspannungsimpuls überlagerten zeitlich veränderlichen Signals bekannt, bei der der Gleichspannungsanteil durch Inversion und Addition des invertierten und des nichtinvertierten Signals eliminiert wird.

Der Erfindung liegt die Aufgabe zugrunde, ein wenig aufwendiges Pegelmeßgerät anzugeben, bei dem die Koppelkondensatoren vermieden werden können.

Diese Aufgabe wird erfindungsgemäß durch die im Patentanspruch angegebenen Merkmale gelöst.

Das erfindungsgemäße Pegelmeßgerät kann auch bei driftenden Gleichspannungen verwendet werden.

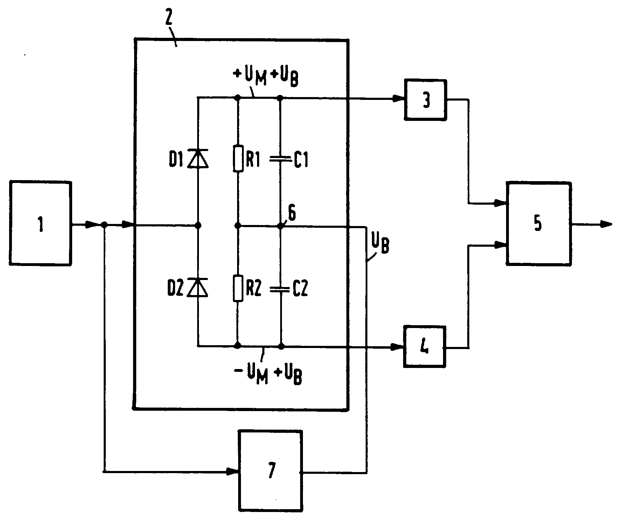

Im folgenden wird die Erfindung anhand eines in der Zeichnung dargestellten Beispieles erläutert.

In der einzigen Figur ist eine Quelle 1 dargestellt, bei der es sich beispielsweise um einen Endverstärker handeln kann. Die Quelle 1 gibt ein NF-Meßsignal an einen Meßgleichrichter 2 und an einen Tiefpaß 7. Der Meßgleichrichter 2 weist zwei Dioden D1 und D2, wobei die Kathode der Diode D1 mit der Anode der Diode D2 verbunden ist, sowie zwei Widerstände R1 und R2 und zwei Kondensatoren C1 und C2 auf.

Das Meßsignal liegt an der Verbindung der beiden Dioden D1 und D2 an. Über die in Flußrichtung gepolte Diode D1 wird aus dem Meßsignal eine positive Gleichspannung $+U_M$ und über die entgegen der Flußrichtung gepolte Diode D2 eine negative Gleichspannung $-U_M$ gebildet. Die Kathode der Diode D1 ist über eine Parallelschaltung aus dem Widerstand R1 und dem Kondensator CI mit einem Bezugspunkt 6 verbunden. Die Anode der Diode D2 ist über eine Parallelschaltung aus dem Widerstand R2 und dem Kondensator C2 ebenfalls mit dem Bezugspunkt 6 verbunden. Die positive und die negative Gleichspannung $+U_M$, $-U_M$ sind jeweils bezogen auf das Potential des Bezugspunktes 6.

Der Bezugspunkt 6 ist mit dem Ausgang des Tiefpaßes 7 verbunden, an dessen Eingang das Meßsignal anliegt. Der Tiefpaß 7 kann ein aktiver Tiefpaß sein, oder auch ein passiver Tiefpaß mit einem nachgeschalteten Impedanzwandler.

Das von der Quelle 1 abgegebene Meßsignal enthält eine NF-Wechselspannung und dieser überlagert eine positive oder negative Gleichspannung. Diese Gleichspannung kann im Laufe der Zeit auch driften.

Durch den Tiefpaß 7 wird aus dem Meßsignal die Gleichspannung herausgefiltert und dient den Gleichrichtern (Dioden D1, D2) des Meßgleichrichters 2 als Bezugspunkt 6 mit einem Bezugspotential $U_B$.

Der über die Diode D1 gleichgerichtete positive Anteil $+U_M$ des NF-Meßsignals, addiert mit dem Bezugspotential $U_B$, liegt am Widerstand R1 und über einen Impedanzwandler 3 an einem Eingang eines Subtrahierers 5 an.

Der über die Diode D2 gleichgerichtete, negative Anteil $-U_M$ des NF-Meßsignals, addiert mit dem Bezugspotential $U_B$, liegt am Widerstand R2 und über einen Impedanzwandler 4 an einem anderen Eingang des Subtrahierers 5 an.

Der Subtrahierer 5 bildet die Differenz aus den beiden anliegenden Signalen:

$$(+U_M + U_B) - (-U_M + U_B) = 2\,U_M$$

Der Subtrahierer 5 gibt dieses Ergebnis $(2U_M)$ als den Pegelmeßwert des Meßsignals ab.

## Patentansprüche

1. Pegelmeßgerät für NF-Meßsignale mit überlagerter Gleichspannung,

   mit einem Tiefpaß (7), an dem das NF-Meßsignal anliegt und dessen Ausgang ein der Gleichspannung entsprechendes Bezugspotential ($U_B$) abgibt,
   mit einem Meßgleichrichter (2) zum Bilden eines positiven und eines negativen, jeweils mit dem Bezugspotential ($U_B$) überlagerten Gleichspannungsanteils ($+U_M$,$-U_M$) jeweils für die positiven und negativen Halbwellen des NF-Meßsignals, wobei das Bezugspotential ($U_B$) an einem Bezugspunkt (6) des Meßgleichrichters (2) anliegt, und
   mit einem Subtrahierer (5), dem eingangsseitig der positive und der negative, jeweils mit dem Bezugspotential ($U_B$) überlagerte Gleichspannunganteil ($+U_M$,$-U_M$) zugeführt sind und der den Pegelmeßwert des NF-Meßsignals abgibt.

## Claims

1. Level-measuring device for low-frequency measurement signals with superimposed direct voltage, having a low-pass filter (7) to which the low-frequency measurement signal is applied and the output of which emits a reference potential ($U_B$) which corresponds to the direct voltage,

   having a meter rectifier (2) for forming a positive and a negative direct-voltage portion ($+U_M$, -

$U_M$), in each case superimposed with the reference potential ($U_B$), for the positive and negative half waves of the low-frequency measurement signal respectively, in which case the reference potential ($U_B$) is applied to a reference point (6) of the meter rectifier (2), and having a subtractor (5) to which, on the input side, the positive and the negative direct-voltage portion (+$U_M$,-$U_M$), in each case superimposed with the reference potential ($U_B$), are supplied and which emits the measured value of the level of the low-frequency measurement signal.

## Revendications

1. Appareil de mesure du niveau de signaux de mesure basse fréquence, auxquels est superposée une tension continue,

   comportant
   un passe-bas (7), auquel est appliqué le signal de mesure basse fréquence et dont la sortie fournit un potentiel ($U_B$) de référence correspondant à la tension continue,
   un redresseur (2) de mesure destiné à la formation de composantes (+$U_M$, -$U_M$) positive et négative de tension continue, qui sont superposées respectivement au potentiel ($U_B$) de référence, pour les alternances positives et négatives du signal de mesure basse fréquence, le potentiel ($U_B$) de référence étant appliqué à un point (6) de référence du redresseur (2) de mesure, et un soustracteur (5), auquel sont envoyées en entrée la composante (+$U_M$) positive de tension continue et la composante négative (-$U_M$) de tension continue superposées chacune au potentiel ($U_B$) de référence et qui fournit la valeur du niveau de mesure du signal de mesure basse fréquence.